# EUROPEAN PATENT APPLICATION

(11) **EP 3 570 442 A1**
(43) Date of publication of application: **20.11.2019**
(21) Application number: 18214314.9
(22) Date of filing: 20.12.2018
(51) Int. Cl.: H03M 13/13, H04L 1/00

(54) **COMPACT TRANSMISSION OF POLAR ENCODED DCI WITH REPETITION FOR 5G COMMUNICATION SYSTEMS**

(30) Priority: 17.05.2018 US 201862672592 P
(71) Applicant: Industrial Technology Research Institute, 31040 Hsinchu (TW)
(72) Inventor: SHIEH, Shin-Lin, 302 Hsinchu County (TW)
(74) Representative: Becker Kurig Straus

(57) **Abstract**

The disclosure is directed to a method of transmitting data encoded in Polar Code and an electronic device using the same method. The data transmission method would include not limited to: determining a bit sequence for transmission; dividing the bit sequence into a first bit sequence and a second bit sequence; generating a first transmission bit stream encoded in Polar Code, ordered from most reliable to least reliable, and including the first bit sequence; generating a second transmission bit stream encoded in Polar Code, ordered from most reliable to least reliable, and including the second bit sequence, wherein the first transmission bit stream has the same length as the second transmission bit stream; transmitting the first transmission bit stream; and transmitting the second transmission bit stream.

## Description

### TECHNICAL FIELD

The present disclosure is directed to a method of transmitting data encoded in Polar Code used by an electronic device and an electronic device using the same method.

### BACKGROUND

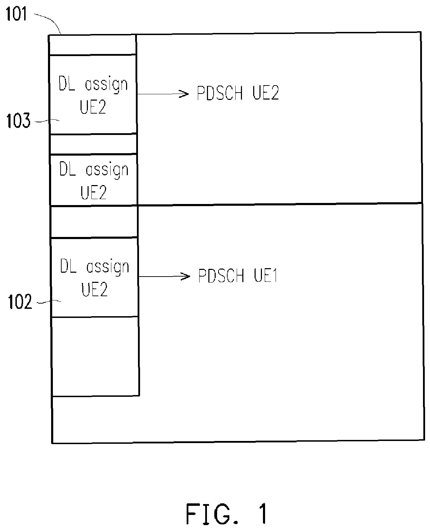

Currently, in the field of 5G communications, various techniques have been proposed to increase the reliability of control channels. In a conventional LTE communication system, physical downlink control channel (PDCCH) has been used to carry downlink control information (DCI) which is typically used to indicate resource assignment for a downlink (DL) or an uplink (UL) per user device. DCI has different formats which may vary depending specific deployment scenarios. FIG. 1 illustrates a conventional technique of allocating resources through the DCI 101. From the DCI 101, a first downlink grant 102 could be allocated for a first user equipment (UE), and a second downlink grant 103 could be allocated for a second user equipment. As the first UE decodes the first downlink grant 102 from the DCI, the first UE would obtain its payload from a physical resource as indicated by the first downlink grant 102 in a physical downlink shared channel (PDSCH), and as the second UE decodes the second downlink grant 103 from the DCI, the second would obtain its payload from another physical resource as indicated by the second downlink grant 103 in the PDSCH.

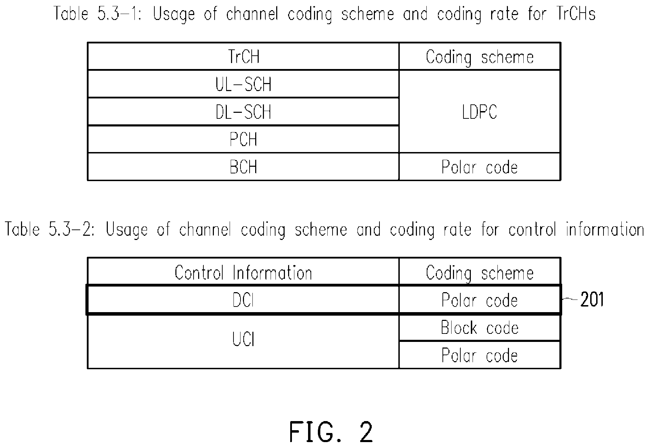

Polar Code is currently a known error correcting code. In the field of 5G communication, Polar Code has been demonstrated to be able to be reliably used for channel coding of control channels during field trials. Thus, the polar code has been adopted in future 5G communication systems as seen in FIG. 2 which shows that Polar Code will be the channel coding scheme to be used for transmitting DCI 201. Communication channels that uses the Polar Code are polarized into two types of channels as each channel would either be an almost noiseless channel or a very noisy channel. The almost noiseless channels would be used for transmission, and the very noisy channels would be frozen and left alone unused. Thus, a bit stream coded under Polar code (i.e. a Polar Sequence) would typically have information bits transmitted under the nearly noiseless channels and frozen bits transmitted under the very noise channels.

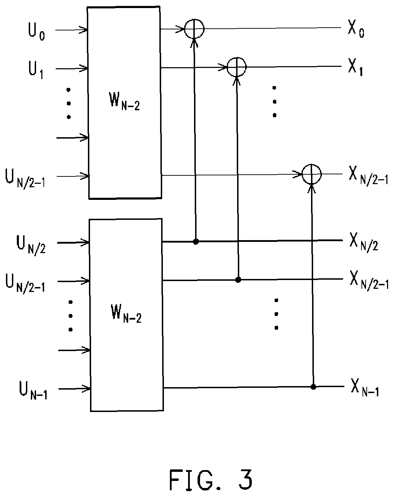

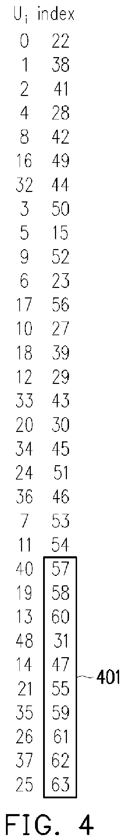

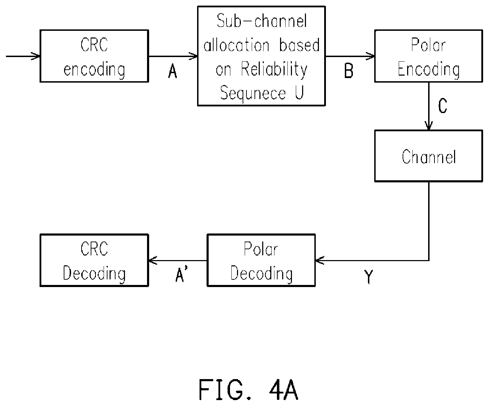

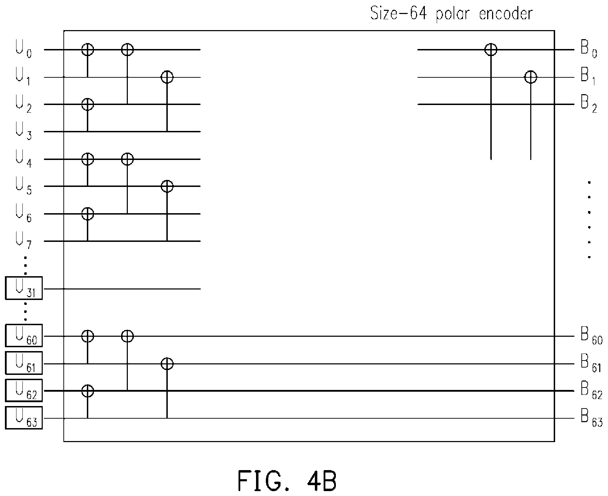

FIG. 3 illustrates a block diagram of a conventional channel coding scheme using Polar Code. A Polar reliability Sequence for a size N kernel could be characterized as having bit index U = {U₀, U₁, ..., U_{N-1}} with reliability characterized as W(U₀) < W(U₁) < ... < W(U_{N-1}) which means that the higher indexed bits are more reliable. The Frozen set index is roughly characterized as UF = {U₀, U₁, ..., U_{|UF|-1}}. The information bits including cycle redundancy check (CRC) bits or PC code pits are characterized as U_{I} = {U_{|UF|}, U_{|UF-1|}, ..., U_{N-1}, U_{F}, U_{F+1}, ..., U_{N-1}}. For example, 10 bits sequenced {B₀, B₁, ..., B₉} is fed into and select 10 positions among U₀, U₁, ..., U_{N-1} according to Uᵢ index shown in FIG. 4 to be encoded by a 64 bits Polar Code indexed from 0 ∼ 63 for transmission. The 10 bits would be placed by the last 10 indices (401) of the 64 indices and thus would be placed by bits indexed 57 58 60 31 47 55 59 61 62 63 as shown in FIG. 4.

In general, suppose that there are A bits to be transmitted in a bit stream having N bits encoded in the conventional Polar Code, the A bits would carried in the A most reliable positions (i.e., the last A indices of the reliability sequence U), encoded by a Polar encoder before transmission.

FIG. 4A illustrates a typical polar encoding and decoding procedure. A set A of |A| bits is placed in reliable positions to form a larger set B of size |B| > |A| before feeding into a polar encoder. After polar encoding the set C with size |B| could be transmitted through a channel to be received by a receiver as a set Y of size |B| bits. The original set A' of size |A| could possibly be recovered from the Y by decoding the |B| bits from a polar decoder.

Suppose that the size of A is 10 as A is represented as A = {A0, A1, ..., A9}, the sizes of B and C are 64, then C would be A encoded into 64 bits. Thus, for the scenario of FIG. 3, the input bits on left side would be 64 bits which include 10 bits of A and 54 frozen bits are set with binary value of 0, and the output bits on the right side would be 64 bits FIG. 4B illustrates a size 64 polar encoder to encode 10 bits as an example. The U index is ordered from the least reliable index to the most reliable index. Therefore, the most reliable U index bits are to be picked to be placed into the encoded A bits. For the scenario of FIG. 4, the 10 most reliable bits for the U index bits 401 are i = 57, 58, 60, 31, 47, ....,62,63). The rest of the U index bits are used as frozen bits which are set with binary value of 0. Thus, referring to FIG. 4B, A0 is placed in U31, A1 is placed in U47, A2 is placed in U55, ...., A9 is placed in U63, and etc. The rest of the U index bits are set with binary value of 0. By using the channel coding scheme of FIG. 3, the set of C could be calculated.

In order to further enhance DCI reliability, several techniques have been proposed. One technique is to use a compact DCI by reducing the number of bits of a conventional DCI. Such technique would enhance the reliability of DCI since having less bits would typically result in an increased reliability. However, there are drawbacks including reduced system or scheduling reliability as well as an increased number of blind detections. Another technique is to repeatedly transmit PDCCH. However, although repetition would increase transmission reliability, it would inevitably increase transmission latency. Therefore, a technique that can achieve an increased control channel reliability but also minimize the above described drawbacks at the same time could be helpful at this time.

### SUMMARY OF THE DISCLOSURE

Accordingly, the present disclosure is directed to a method of transmitting data encoded in Polar Code used by an electronic device, and an electronic device using the same method.

In one of the exemplary embodiments, the present disclosure is directed to a data transmission method used by a transmitter, the method would include not limited to: determining a bit sequence for transmission; dividing the bit sequence into a first bit sequence and a second bit sequence; generating a first transmission bit stream encoded in Polar Code, ordered from most reliable to least reliable, and including the first bit sequence; generating a second transmission bit stream encoded in Polar Code, ordered from most reliable to least reliable, and including the second bit sequence, wherein the first transmission bit stream has the same length as the second transmission bit stream; transmitting the first transmission bit stream; and transmitting the second transmission bit stream.

In one of the exemplary embodiments, the present disclosure is directed to an electronic device which would include not limited to: a transmitter; and a processor coupled to the transmitter and configured at least to: determine a bit sequence for transmission; divide the bit sequence into a first bit sequence and a second bit sequence; generate a first transmission bit stream encoded in Polar Code, ordered from most reliable to least reliable, and including the first bit sequence ; generate a second transmission bit stream encoded in Polar Code, ordered from most reliable to least reliable, and including the second bit sequence , wherein the first transmission bit stream has the same length as the second transmission bit stream; transmit, by using the transmitter, the first transmission bit stream; and transmit, by using the transmitter, the second transmission bit stream.

In order to make the aforementioned features and advantages of the present disclosure comprehensible, exemplary embodiments accompanied with figures are described in detail below. It is to be understood that both the foregoing general description and the following detailed description are exemplary, and are intended to provide further explanation of the disclosure as claimed.

It should be understood, however, that this summary may not contain all of the embodiments of the present disclosure and is therefore not meant to be limiting or restrictive in any manner. Also, the disclosure would include improvements and modifications which are obvious to one skilled in the art.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1 illustrates a conventional technique of allocating resources through a control channel.
FIG. 2 illustrates the use of Polar Code for channel coding of DCI in a 5G communication system.
FIG. 3 illustrates a block diagram of a conventional channel coding scheme using Polar Code
FIG. 4 illustrates a bit sequence of a conventional Polar Code.
FIG. 4A illustrates a typical polar encoding and decoding procedure.
FIG .4B illustrates a size 64 polar encoder to encode 10 bits as an example.
FIG. 5 illustrates a scheme of a control channel transmission coded under Polar Code in accordance with one of the exemplary embodiments of the disclosure.
FIG. 5A illustrates an example of a control channel transmission coded under Polar Code in accordance with one of the exemplary embodiments of the disclosure.
FIG. 6 illustrates a scheme of a control channel transmission with CRC bits coded under Polar Code in accordance with one of the exemplary embodiments of the disclosure.
FIG. 7 illustrates alternative variations of control channel transmission coded under Polar Code in accordance with one of the exemplary embodiments of the disclosure.
FIG. 8 illustrates another set of alternative variations of control channel transmission coded under Polar Code in accordance with one of the exemplary embodiment of the disclosure.
FIG. 9 illustrates another exemplary embodiment of a control channel transmission coded under Polar Code.
FIG. 10 illustrates bits mapping of a control channel transmission with CRC bits coded under Polar Code in accordance with one of the exemplary embodiments of the disclosure.
FIG. 11 illustrates a method of transmitting data encoded in Polar Code used by an electronic device in accordance with one of the exemplary embodiments of the disclosure.
FIG. 12 illustrates an electronic device which uses the method of transmitting data encoded in Polar Code in accordance with one of the exemplary embodiments of the disclosure.

### DETAILED DESCRIPTION OF DISCLOSED EMBODIMENTS

Reference will now be made in detail to the present exemplary embodiments of the disclosure, examples of which are illustrated in the accompanying drawings. Wherever possible, the same reference numbers are used in the drawings and the description to refer to the same or like parts.

The disclosure proposes a method and an electronic device which transmits data encoded in Polar Code. The method could be applicable for transmitting control channel information such as DCI. Even though the rest of this disclosure describes transmitting DCI (which is typically carried within a PDCCH), the technique as described in this disclosure could be extended other types of control channel information. Further, the disclosure proposes transmitting the complete control channel information (e.g. full DCI) as well as control channel information in compact form (e.g. compact DCI) but with smart repetition.

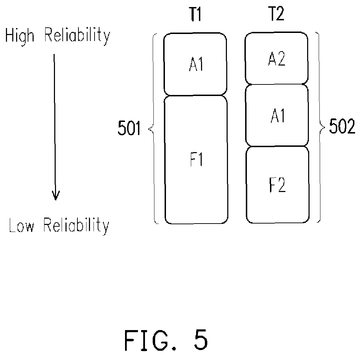

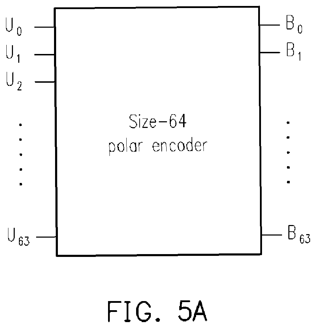

FIG. 5 illustrates a scheme of a control channel transmission coded under Polar Code in accordance with one of the exemplary embodiments of the disclosure. The scheme of FIG. 5 is suitable for both complete DCI and compact DCI. Suppose that a base station has determined to transmit a complete DCI having a bit sequence to a UE, and A stands for a complete DCI, the proposed technique would split A into two parts, namely, A1 and A2 so that A = (A1 U A2), where A1 is a first bit sequence and A2 is a second bit sequence. In other words, A1 is a part of the complete DCI and A2 is the other part of the complete DCI, but the disclosure is not limited to the DCI being split into just two parts. The proposed technique can be extended to splitting DCI into more than two parts. The length of A1 could be the same, smaller, or larger than the length of A2.

A1 would be placed into a part of a first transmission bit stream 501 which is then encoded by a polar encoder , ordered from most reliable to least reliable, and to be transmitted at time T1. The first transmission bit stream 501 to be encoded would further include a first set of frozen bits F1 followed by A1. A2 would also be placed into a part of a second transmission bit stream 502 which is then encoded by a polar encoder, ordered from most reliable to least reliable, and to be transmitted at time T2. Furthermore, the second transmission bit stream 502 to be encoded would also include A1 followed by a second set of frozen bits (F2). A1 is the first bit sequence which has been repeated once. The encoding of the first transmission bit stream 501 which includes A1 and the encoding of the second transmission bit stream 502 which includes A1 and A2 could be based on any known Polar Code technique. That the first transmission bit stream 501 would typically have the same length as the second transmission bit stream 502, and time T2 would occur after time T1.

For the embodiment of FIG. 5, A1 would contain more critical information than A2 and thus A1 is transmitted first. In this exemplary embodiment, the length of A1 is longer than A2 and thus most of the information is transmitted at time T1, and A1 would subsequently be decoded by at a receiver's end such as a UE. The second transmission bit stream 502 to be encoded and transmitted at time T2 would include A2 which takes up the most reliable location of the second transmission bit stream 502, and A1 is to be repeated once in less reliable location than the location of A2. However, since A1 is repeated once, A1 would also likely to be reliably decoded by a UE. After obtaining both A1 and A2, the complete DCI would be A1 in addition to A2.

FIG. 5A shows an example of a control channel transmission coded under a size-64 polar encoder in accordance with one of the exemplary embodiments of the disclosure. Referring to the example of FIG. 5, it is supposed that A being 10 bits = {M0, M1, M2, ...,M9}, A1 being 4 bits = {M0, M1, M2, M3}, and A2 being 6 bits = {M4, M5, ..., M9}. At time T1, the 4 A1 bits would be combined with 60 frozen bits and be loaded into the left side of the size-64 polar encoder of FIG. 5A. In particular, M0 is placed in U59, M1 is placed in U61, M2 is placed in U62, and M3 is placed in U63. Thus, 64 bits of the first transmission bit stream 501 could be calculated by the size 64 Polar encoder. At time T2, the 10 bits with the A2 bits being placed in more reliable locations than the A1 bits are combined with 54 frozen bits, the 64 total bits are then loaded into the left side of the 64 bits Polar encoder with M4 placed into U47, M5 placed into U55, M6 placed into U59, M7 placed into U61, M8 placed into U62, M9 placed into U64, M0 placed into U31, M1 placed into U57, M2 placed into U58, and M3 placed into U60. Thus, the 64 bits of the second transmission bit stream 502 could be calculated accordingly by the size-64 Polar encoder of FIG. 5A.

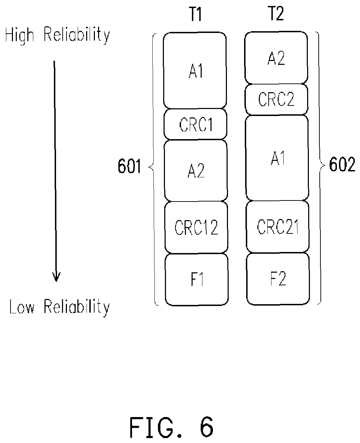

FIG. 6 illustrates a similar scheme as FIG. 5 except with the addition of using CRC bits to further enhance the reliability of A1 and A2. Moreover, in the first transmission bit stream 601, A1 would be followed by CRC1, and A2 is also repeated in the second transmission bit stream 602 but its location relative to A1 is flipped. As shown in FIG. 6, the first transmission bit stream 601 includes the sequence A1, CRC1, A2, CRC12, and F1 that are encoded by Polar Code and ordered from most reliable to least reliable. In comparison to the exemplary embodiment of FIG. 5, the first transmission bit stream 601 further includes a first set of error correction bits CRC1 which could be based on any known error correction scheme and protects the signal integrity of A1. The second set of error correction bits (CRC12) would protect the signal integrity of the combination of A1 and then A2. Similarly, the second transmission bit stream 602 contains the sequence A2, CRC2, A1, CRC21, and F2 that are encoded by Polar Code and ordered from most reliable to least reliable. In comparison to the exemplary embodiment of FIG. 5, the second transmission bit stream 602 further includes a third set of error correction bits CRC2 which could be based on any known error correction scheme and protects the signal integrity of A2. The fourth set of error correction bits (CRC21) would protect the signal integrity of the combination of A2 and then A1.

For the first transmission bit stream 601, suppose that A1 contains no error upon decoding, the integrity of A1 can be examined and justified by using CRC1. Since A2 is transmitted in a less reliable location than A1, A2 could have uncorrectable error bits which are found by using CRC12. Even if A2 cannot be reliably decoded, At T2, A2 is repeated in the second transmission bit stream 602 at highly reliable locations. Since A1 is correct at time T1 and A2 is put in reliable locations at time T2, A2 could be highly reliable at time T2.. Once A2 is deemed highly reliable after being checked by CRC2, A1 could be singled out from the combination of A2 + A1 and be corrected by using CRC21.

A1 that has been decoded from the second transmission bit stream 602 could be compared with A1 from the first transmission bit stream 601 since A1 from both the first transmission bit stream 601 and second transmission bit stream 602 supposes to be identical. Similarly, the signal integrity of A2 could be checked and corrected multiple ways including the repetition as well as the CRC checks including CRC2, CRC21, and CRC12.

In general, upon receiving the first transmission bit stream 601, the UE can buffer the data received from the first transmission bit stream 601. Upon receiving the second transmission bit stream 602, the UE would be able to obtain the most reliable bit stream from either A1 or A2 based on whichever is put in the reliable position. After obtaining the most reliable bit stream which is one of A1 or A2, the UE would be able to obtain the other based on repetition and / or the CRC check.

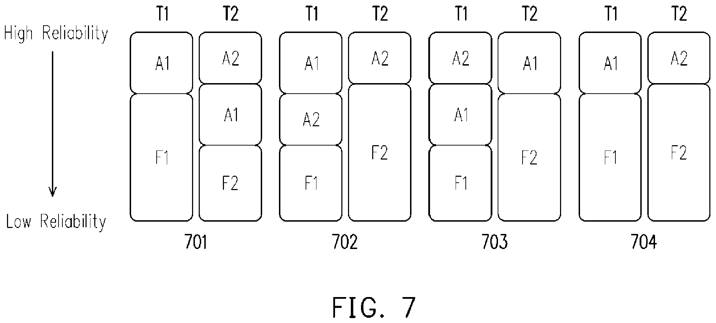

To further expand upon the concepts of using compact data, repeated information, and error correction code as shown in FIG. 5 and FIG. 6, FIG. 7 illustrates several variations of control channel transmission coded under Polar Code. One of the several variations could be selected based on the deployment locations of UEs relative to their serving base station. More specifically, FIG. 7 shows four variations including a first scenario 701, a second scenario 702, a third scenario 703, and a fourth scenario 704.

For the first scenario 701, the first transmission bit stream may include A1 and F1 and be transmitted at time T1, the second transmission bit stream may include A2 which is followed by A1 which is followed by F2. A1 in the first scenario 701 is repeated for the second transmission bit stream but in a less reliable location. When operating under the first scenario 701, all UEs can decode A1 at time T1. Alternatively, UEs could be divided into edge UEs which are close to being at an edge of a cell and central UEs which are not close to being at any edge of the cell. Since signals at an edge of the cell are considered less reliable, edge UEs could be required to obtain both the first transmission bit stream at time T1 and second transmission bit stream at time T2 in order to reliably obtain both A1 and A2. For central UEs which would be able to obtain more reliable signals, central UEs would only need to decode the second transmission bit stream at time T2 to reliably obtain both A1 and A2. Therefore, under the first scenario 701, central UEs could save power.

For the second scenario 702, the first transmission bit stream may include A1, A2, and F1 and be transmitted at time T1, the second transmission bit stream may include A2 which is followed by F2. A2 in the second scenario 702 is repeated for the first transmission bit stream but in a less reliable location. When operating under the second scenario 702, central UEs would only need to obtain and decode the first transmission bit stream for both A1 and A2. Edge UEs would buffer the data decoded from the first transmission bit stream which is transmitted at time T1. After receiving the second transmission bit stream which is transmitted at time T2, edge UEs would be able to reliably decode A2 from the second transmission bit stream. By treating A2 as a valid prior information, edge UEs would able to reliably decode A1 from the buffered data.

For the third scenario 703, the first transmission bit stream may include A2, A1, and F1 and be transmitted at time T1, the second transmission bit stream may include A1 which is followed by F2. A1 in the third scenario 703 is repeated for the first transmission bit stream but in a less reliable location. When operating under the third scenario 703, central UEs would only need to obtain and decode the first transmission bit stream for both A1 and A2. Edge UEs would buffer the data decoded from the first transmission bit stream which is transmitted at time T1. After receiving the second transmission bit stream which is transmitted at time T2, edge UEs would be able to reliably decode A1 from the second transmission bit stream. By treating A1 as a valid prior information, edge UEs would able to reliably decode A2 from the buffered data.

For the fourth scenario 704, the first transmission bit stream may include A1 which is followed by F1, and the second transmission bit stream may include A2 which is followed by F2. When operating under the fourth scenario 704, all UEs, regardless of being edge UEs or central UEs, would need to obtain A1 at time T1. Also, all UEs would need to obtain A2 at time T2. All UEs would need to decode both the first transmission bit stream and the second transmission bit stream in order to obtain A1 and A2.

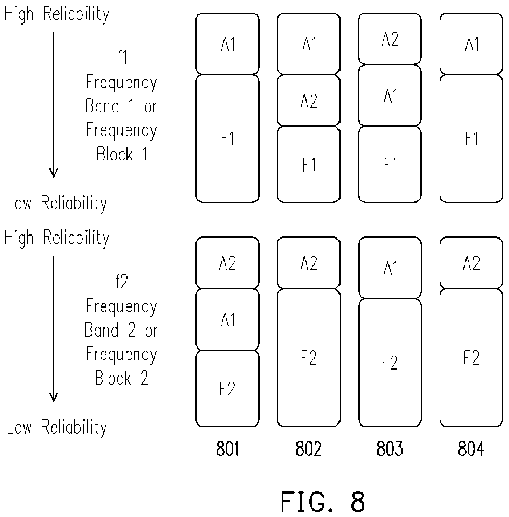

FIG. 8 illustrates another set of alternative variations of control channel transmission coded under Polar Code in accordance with one of the exemplary embodiments of the disclosure. The four variations including a first scenario 801, a second scenario 802, a third scenario 803, and a fourth scenario 804 which are similar to the four scenarios 701 702 703 703 of FIG. 3. But for each scenario, the first transmission bit stream and the second transmission bit stream are transmitted in different frequency bands or frequency blocks. For example, the first transmission bit stream of the first scenario 801 is transmitted in f₁ frequency band or frequency block, and the second transmission bit stream of the first scenario 801 is transmitted in f₂ frequency band or frequency block, where f₁ is different or does not overlap f₂. Also, for each scenario, the first transmission bit stream and the second transmission bit stream are transmitted could be simultaneously transmitted in the same time slot.

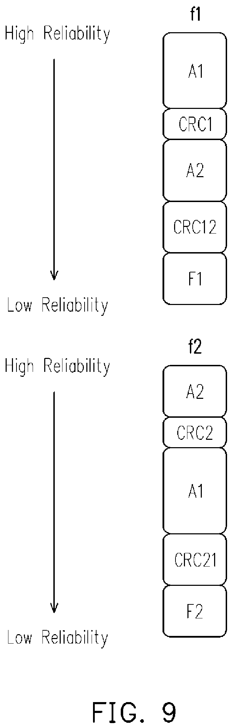

FIG. 9 illustrates another exemplary embodiment which is similar to FIG. 6 and uses error correction codes and reverses the corresponding reliability order of A1 and A2 between the first transmission bit stream and the second transmission bit stream. However, the first transmission bit stream 601 is transmitted over the f₁ frequency band or frequency block and the second transmission bit stream 602 is transmitted over the f₂ frequency band or frequency block. The first transmission bit stream 601 and the second transmission bit stream 602 could be simultaneously transmitted in the same time slot.

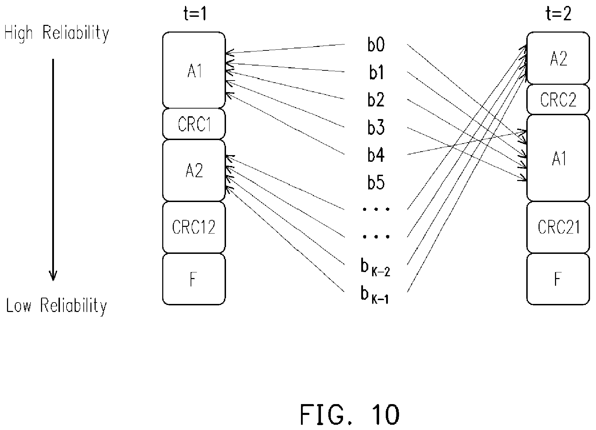

FIG. 10 illustrates bits mapping of a control channel transmission with CRC bits coded under Polar Code in accordance with one of the exemplary embodiments of the disclosure. Assuming that a complete DCI has k bits numbered from b₀ to bₖ₋₁, the k DCI bits could be split into A1 which includes b₀ ∼ b₅ and A2 which includes b₆ ∼ bₖ₋₁. A1 and A2 are reversing the corresponding reliability order between the first transmission bit stream and the second transmission bit stream, but contain the same subset of DCI bits.

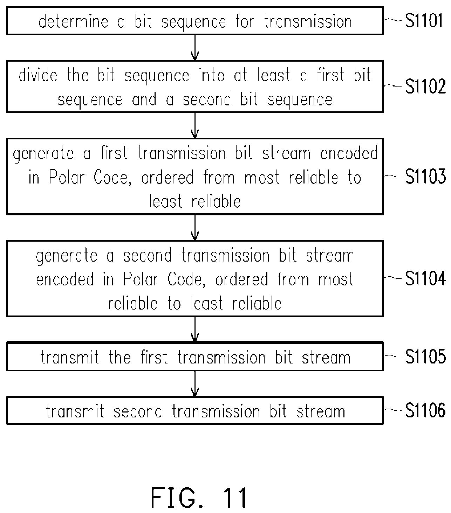

FIG. 11 illustrates a method of transmitting data encoded in Polar Code used by an electronic device in accordance with one of the exemplary embodiments of the disclosure. The method is suitable for transmitting information of a control channel which could be DCI or other control channels. The electronic device could be a UE or any communication device having 5G capability and beyond. The electronic device could be also be a base station or any communication apparatus in the radio access network or the core network.

In step S1101, the electronic device would determine a bit sequence (e.g. A= A1 + A2 + ...) for transmission. In step S1102, the electronic device would divide the bit sequence (e.g. A) into at least a first bit sequence (A1) and a second bit sequence (A2). In step S1103, the electronic device would generate a first transmission bit stream (A1 + F1) encoded in Polar Code, ordered from most reliable to least reliable. The first transmission bit stream would include the first bit sequence (A1) followed by a first set of frozen bits (F1). The step S1104, the electronic device would generate a second transmission bit stream (A2 + F2) encoded in Polar Code, ordered from most reliable to least reliable. The second transmission bit stream would include the second bit sequence (A2) followed by a second set of frozen bits (F2). The first transmission bit stream would typically have the same length as the second transmission bit stream. In step S1105, the electronic device would transmit the first transmission bit stream. In step S1106, the electronic device would transmit second transmission bit stream. It worth noting that step S1105 may occur before or after step S1106. Steps S1105 and S1106 may also occur simultaneously. Information contained in first bit sequence (A1) could be considered as being more critical than the second bit sequence (A2).

In one of the exemplary embodiments, the second transmission bit stream may further include the first bit sequence (A1) which is located after the second bit sequence (A2) and before the second set of frozen bits (F2). In one of the exemplary embodiments, the first transmission bit stream further comprising the second bit sequence (A2) which is located after the first bit sequence (A1) and before the first set of frozen bits (F1). In one of the exemplary embodiments, transmission of the first transmission bit stream may occur after transmission of the second transmission bit stream, where the second bit sequence (A2) is considered more critical than the first bit sequence (A1), and the second transmission bit stream may further include the first bit sequence (A1) which is located after the second bit sequence (A2) and before the second set of frozen bits (F2).

In one of the exemplary embodiments, the first transmission bit stream may further include a first set of error correction bits (CRC1) which is used for checking the first bit sequence (A1) and is located between the first bit sequence (A1) and the first set of frozen bits (F1). In one of the exemplary embodiments, the first transmission bit stream may further include a second set of error correction bits (CRC12) which is used for checking the first bit sequence (A1) followed by the second bit sequence (A2) and is located after the second bit sequence (A2) and before the first set of frozen bits (F1). In one of the exemplary embodiments, the second transmission bit stream may further include a third set of error correction bits (CRC2) which is used for checking the second bit sequence (A1) and is located after the second bit sequence (A2) and before the second set of frozen bits (F2). In one of the exemplary embodiments, the second transmission bit stream may further include a fourth set of error correction bits (CRC21) which is used for checking the second bit sequence (A2) followed by the first bit sequence (A1) and is located after the first bit sequence (A1) and before the first set of frozen bits (F2).

In one of the exemplary embodiments, transmission of the first transmission bit stream may occur in a first frequency band, and transmission of the second transmission bit stream may occur in another frequency band but in the same time slot. In one of the exemplary embodiments, the first bit sequence (A1) may have a different length from the second bit sequence (A2).

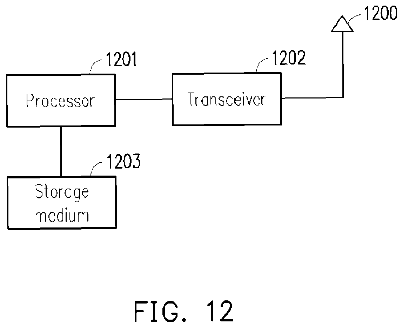

FIG. 12 illustrates an electronic device which uses the method of transmitting data encoded in Polar Code in accordance with one of the exemplary embodiments of the disclosure. The electronic device could be a UE or any communication device having 5G capability and beyond. The electronic device could be also be a base station or any communication apparatus in the radio access network or the core network. The base station may include not limited to a hardware processor 1201, a hardware transceiver 1202, and a non-transitory storage medium 1203. The hardware processor 1201 are electrically connected to the hardware transceiver 1202 and the non-transitory storage medium 1203 and configured at least for implementing the method of transmitting data encoded in Polar Code used by an electronic device as well as its exemplary embodiments and alternative variations, and the method may include not limited to determining a bit sequence for transmission; dividing the bit sequence into a first bit sequence (A1) and a second bit sequence (A2); generating a first transmission bit stream encoded in Polar Code, ordered from most reliable to least reliable, and including the first bit sequence (A1) followed by a first set of frozen bits (F1); generating a second transmission bit stream encoded in Polar Code, ordered from most reliable to least reliable, and including the second bit sequence (A2) followed by a second set of frozen bits (F1), wherein the first transmission bit stream has the same length as the second transmission bit stream; transmitting the first transmission bit stream; and transmitting the second transmission bit stream.

The hardware transceiver 1202 may include one or more transmitters and receivers configured to transmit and receive signals respectively in the radio frequency or in the mmWave frequency. The hardware transceiver 1202 may also perform operations such as low noise amplifying, impedance matching, frequency mixing, up or down frequency conversion, filtering, amplifying, and so forth. The hardware transceiver 1202 may each include one or more analog-to-digital (A/D) and digital-to-analog (D/A) converters which are configured to convert from an analog signal format to a digital signal format during uplink signal processing and from a digital signal format to an analog signal format during downlink signal processing. The hardware transceiver 1202 may further include an antenna array which may include one or multiple antennas to transmit and receive omni-directional antenna beams or directional antenna beams.

The hardware processor 1201 is configured to process digital signals and to perform procedures of the proposed method of network slicing in accordance with the proposed exemplary embodiments of the disclosure. Also, the hardware processor 1201 may access to the non-transitory storage medium 1203 which stores programming codes, codebook configurations, buffered data, and record configurations assigned by the hardware processor 1201. The hardware processor 1201 could be implemented by using programmable units such as a micro-processor, a micro-controller, a DSP chips, FPGA, etc. The functions of the hardware processor 1201 may also be implemented with separate electronic devices or ICs. It should be noted that the functions of hardware processor 1201 may be implemented with either hardware or software.

In view of the aforementioned descriptions, the disclosure is suitable for being used in a wireless communication system and is able to increase the reliability of control channel transmission which is encoded in Polar Code but at the same time minimizing disadvantages associated with the conventional Polar Code transmission scheme.

No element, act, or instruction used in the detailed description of disclosed embodiments of the present application should be construed as absolutely critical or essential to the present disclosure unless explicitly described as such. Also, as used herein, each of the indefinite articles "a" and "an" could include more than one item. If only one item is intended, the terms "a single" or similar languages would be used. Furthermore, the terms "any of' followed by a listing of a plurality of items and/or a plurality of categories of items, as used herein, are intended to include "any of', "any combination of', "any multiple of', and/or "any combination of multiples of the items and/or the categories of items, individually or in conjunction with other items and/or other categories of items. Further, as used herein, the term "set" is intended to include any number of items, including zero. Further, as used herein, the term "number" is intended to include any number, including zero.

## Claims

1. A method of transmitting data encoded in Polar Code used by an electronic device, the method comprising:
determining a bit sequence (A1 + A2) for transmission (S1101);
dividing the bit sequence into a first bit sequence (A1) and a second bit sequence (A2) (S1102);
generating a first transmission bit stream (501) encoded in Polar Code, ordered from most reliable to least reliable, and comprising the first bit sequence (A1) (S1103);
generating a second transmission bit stream (502) encoded in Polar Code, ordered from most reliable to least reliable, and comprising the second bit sequence (A2), wherein the first transmission bit stream (501) has the same length as the second transmission bit stream (502) (S1104);
transmitting the first transmission bit stream (501) (S1105); and
transmitting the second transmission bit stream (502) (S1106).

2. The method of claim 1, wherein transmitting the first transmission bit stream (501) occurs before transmitting the second transmission bit stream (502), and the first bit sequence (A1) is more critical than the second bit sequence (A2).

3. The method of claim 2, wherein the second transmission bit stream (502) further comprising the first bit sequence (A1) which is located after the second bit sequence (A2) and before a second set of frozen bits (F2).

4. The method of claim 2, wherein the first transmission bit stream (601) further comprising the second bit sequence (A2) which is located after the first bit sequence (A1) and before a first set of frozen bits (F1).

5. The method of claim 1, wherein transmitting the first transmission bit stream (601) occurs after transmitting the second transmission bit stream (602), the second bit sequence (A2) is more critical than the first bit sequence (A1), and the second transmission bit stream (602) further comprising the first bit sequence (A1) which is located after the second bit sequence (A2) and before the second set of frozen bits (F2).

6. The method of claim 4, wherein the first transmission bit stream (601) further comprising a first set of error correction bits (CRC1) which is used for checking the first bit sequence (A1) and is located between the first bit sequence (A1) and the first set of frozen bits (F1).

7. The method of claim 6, wherein the first transmission bit stream (601) further comprising a second set of error correction bits (CRC12) which is used for checking the first bit sequence (A1) followed by the second bit sequence (A2) and is located after the second bit (A2) sequence and before the first set of frozen bits (F1).

8. The method of claim 7, wherein the second transmission bit stream (602) further comprising a third set of error correction bits (CRC2) which is used for checking the second bit sequence (A2) and is located after the second bit sequence (A2) and before the second set of frozen bits (F2).

9. The method of claim 8, wherein the second transmission bit stream (602) further comprising a fourth set of error correction bits (CRC21) which is used for checking the second bit sequence (A2) followed by the first bit sequence (A1) and is located after the first bit sequence (A1) and before the second set of frozen bits (F2).

10. The method of claim 1, wherein transmitting the first transmission bit stream (501 601) occurs in a first frequency band and transmitting the second transmission bit stream (502 602) occurs in another frequency band but the same time slot.

11. The method of claim 1, wherein the first bit sequence (A1) has a different length from the second bit sequence (A2).

12. An electronic device comprising:
a transmitter (1202); and
a processor (1201) coupled to the transmitter (1202) and configured at least to:
determine a bit sequence (A1 + A2) for transmission;
divide the bit sequence into a first bit sequence (A1) and a second bit sequence (A2);
generate a first transmission bit stream (501) encoded in Polar Code, ordered from most reliable to least reliable, and comprising the first bit sequence (A1);
generate a second transmission bit stream (502) encoded in Polar Code, ordered from most reliable to least reliable, and comprising the second bit sequence (A2), wherein the first transmission bit stream (501) has the same length as the second transmission bit stream (502);
transmit, by using the transmitter, the first transmission bit stream (501); and
transmit, by using the transmitter, the second transmission bit stream (502).

13. The electronic device of claim 12, wherein the processor (1201) configured to transmit the first transmission bit stream (501) occurs before transmit the second transmission bit stream (502), and first bit sequence (A1) is more critical than the second bit sequence (A2).

14. The electronic device of claim 13, wherein the second transmission bit stream (502) further comprising the first bit sequence (A1) which is located after the second bit sequence (A2) and before a second set of frozen bits (F2).

15. The electronic device of claim 13, wherein the first transmission bit stream (601) further comprising the second bit sequence (A2) which is located after the first bit sequence (A1) and before a first set of frozen bits (F1).

16. The electronic device of claim 12, wherein the processor (1201) configured to transmitting the first transmission bit stream (601) occurs after transmitting the second transmission bit stream (602), the second bit sequence (A2) is more critical than the first bit sequence (A1), and the second transmission bit stream further comprising the first bit sequence (A1) which is located after the second bit sequence (A2) and before the second set of frozen bits (F2).

17. The electronic device of claim 15, wherein the first transmission bit stream (601) further comprising a first set of error correction bits (CRC1) which is used for checking the first bit sequence (A1) and is located between the first bit sequence (A1) and the first set of frozen bits (F1).

18. The electronic device of claim 17, wherein the first transmission bit stream (601) further comprising a second set of error correction bits (CRC12) which is used for checking the first bit sequence (A1) followed by the second bit sequence (A2) and is located after the second bit sequence (A2) and before the first set of frozen bits (A1).

19. The electronic device of claim 18, wherein the second transmission bit stream (602) further comprising a third set of error correction bits (CRC2) which is used for checking the second bit sequence (A2) and is located after the second bit sequence (A2) and before the second set of frozen bits (F2).

20. The electronic device of claim 19, wherein the second transmission bit stream (602) further comprising a fourth set of error correction bits (CRC21) which is used for checking the second bit sequence (A2) followed by the first bit sequence (A1) and is located after the first bit sequence (A1) and before the second set of frozen bits (F2).

21. The electronic device of claim 12, wherein the processor (1201) is configured to transmit the first transmission bit stream (501 601) occurs in a first frequency band and transmit the second transmission bit stream (502 602) occurs in another frequency band but the same time slot.

22. The electronic device of claim 12, wherein the first bit sequence (A1) has a different length from the second bit sequence (A2).
